# EUROPEAN PATENT APPLICATION

(11) **EP 3 327 791 A1**
(43) Date of publication of application: **30.05.2018**
(21) Application number: 16200526.8
(22) Date of filing: 24.11.2016
(51) Int. Cl.: H01L 29/808, H01L 29/423, H01L 29/10, H01L 29/16, H01L 29/20

(54) **JUNCTION FIELD-EFFECT TRANSISTOR**

(71) Applicant: ABB Schweiz AG, 5400 Baden (CH)
(72) Inventor: MIHAILA, Andrei, 5400 Baden (CH); MINAMISAWA, Renato, 5200 Brugg (CH); SUNDARAMOORTHY, Vinoth, 5430 Wettingen (CH); KNOLL, Lars, 5415 Nussbaumen (CH)
(74) Representative: ABB Patent Attorneys

(57) **Abstract**

A junction field effect transistor comprising from a drain side (80) to a source side (90) an n+ doped drain layer (1), an n- doped drift layer (2), an n doped channel region (3), an n doped mesa region (4) and an n+ doped source layer (5).

A trench (7, 7') extends from the source side (90) through the source layer (5) and the mesa region (4) to the gate region (3). The trench (7, 7') has a lateral trench side wall (74, 74'), which is covered with an insulating layer (72, 72') having a thickness between 5 and 100 µm, and a trench bottom (76, 76'). An electrically conductive gate layer (70, 70') covers the insulating layer (72, 72') on a side opposite to the trench side wall (74, 74') from the trench bottom (76, 76') to a depth from the source side (90) less than a source layer depth (50).

A p doped gate region (6, 6') is arranged below the trench (7, 7'), which contacts the gate layer (70, 70') at the trench bottom (76, 76').

## Description

### Technical Field

The invention relates to the field of power electronics and more particularly to a junction field-effect transistor according to the preamble of claim 1.

### Background Art

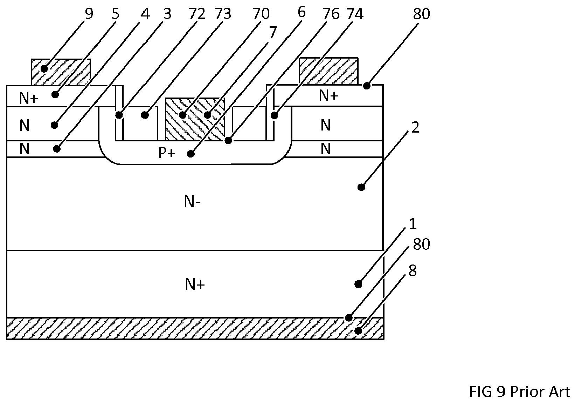

A prior art junction field-effect transistor (JFET) is shown in FIG 9. The device comprises from a drain side (80) to a source side (90) following layers:
- an doped drain layer 1, which contacts a drain electrode 8,
- an n- doped drift layer 2, which is lower doped than the drain layer 1,
- an n- doped channel region 3, which has a higher doping concentration than the drift layer 2,
- an n doped mesa region 4, has the same doping concentration as the channel region 3,
- an n+ doped source layer 5, which is higher doped than the mesa region 4, wherein the source layer 5 contacts a source electrode 9.

A p doped gate region 6 is arranged lateral to the n doped channel region 3. The channel region 3 is arranged on the drift layer 2 towards the source side 90 and alternatingly to the p gate region. The mesa region 4 is arranged between the n+ source layer 5 and the channel region 3.

A trench 7 extends from the source side 90 through the source layer 5 and the mesa region 4 to the drift layer 2. The trench 7 has a lateral trench side wall 74 and a trench bottom 76, wherein the trench side wall 74 extends from the source side 90 to the trench bottom 76. The trench side wall 74 is covered with an insulating layer 72.

Below the trench 7, a p doped gate region 6 is arranged, which also covers the trench side walls 74 up to the source layer 5 so that the p doped gate region 6 separates the insulating layer 72 from the n doped regions 3, 4. The gate region 6 contacts an electrically conductive gate layer 70 at the trench bottom 76. It is arranged laterally from the mesa region 4 and the insulating layer 72. However, a thick, further insulating layer 73 between the gate layer 70 and the insulating layer 72 ensures a good electrical insulation between the gate layer 70 and the gate region 6. The channel region 3 and mesa region 4 with the higher doping concentration than the drift layer 2 provide a reduced channel resistivity for lower conduction losses, but at the same time the blocking is deteriorated. On the other hand, lower leakage currents would be achieved with a lower doping concentration at the channel and mesa region 3, 4, but this would increase the conduction losses.

However, a semiconductor with low conduction losses and required blocking capability is necessary for event switching applications such as circuit breakers, contactors, current limiters, etc. In such applications, low conduction losses are a crucial ingredient to reduce the cooling requirements.

### Disclosure of Invention

It is an object of the invention to provide a junction field-effect transistor with improvements in view of conduction losses and leakage current.

This object is achieved by a junction field-effect transistor according to the invention.

A junction field effect transistor (JFET) is provided comprising from a drain side to a source side following layers:
- a drain layer of a first conductivity type, which contacts a drain electrode,
- a drift layer of the first conductivity type, which is lower doped than the drain layer,
- a channel region of the first conductivity type, which is doped at least as high as the drift layer,
- a mesa region of the first conductivity type, which is doped at least as high as the drift layer and
- a source layer of the first conductivity type, which is higher doped than the mesa region, wherein the source layer contacts a source electrode, which source layer extends to a source layer depth from the source side.

A trench extends from the source side through the source layer and the mesa region to the gate region. The trench has a lateral trench side wall, which extends from the source side to a trench bottom, and the trench bottom. The trench side wall is covered with an insulating layer, which has a thickness between 5 to 100 µm. An electrically conductive gate layer covers the insulating layer on a side opposite to the trench side wall, which insulating layer separates the gate layer from the layers of the first conductivity type. The gate layer extends towards the source side to a depth from the source side, which is less than the source layer depth.

A gate region of a second conductivity type different from the first conductivity type, which is higher doped than the drift layer, is arranged below the trench, wherein the gate layer contacts the gate region at the trench bottom.

The mesa region extends from the source layer to the trench bottom. It touches the trench at the trench side wall so that no layer of the second conductivity type extends to and touches the source layer. The channel region extends from the trench bottom to a gate region bottom.

Due to the gate layer extending from the contact to the p doped gate region to an area in projection to the source layer, the overall gate resistance is reduced, i.e. the voltage drop along the gate structure, which may be in form of gate fingers. This improves uniformity of the gate electrostatics over the device area, thereby reducing leakage current and improving conduction.

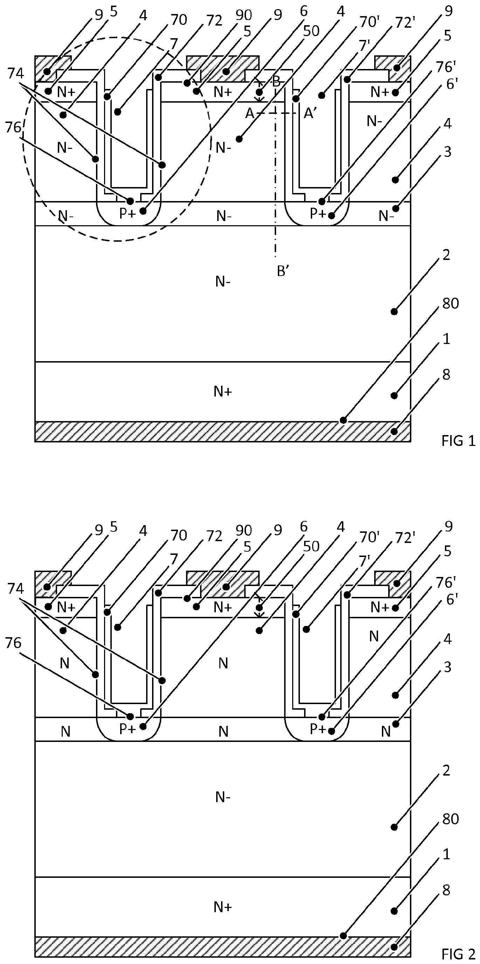

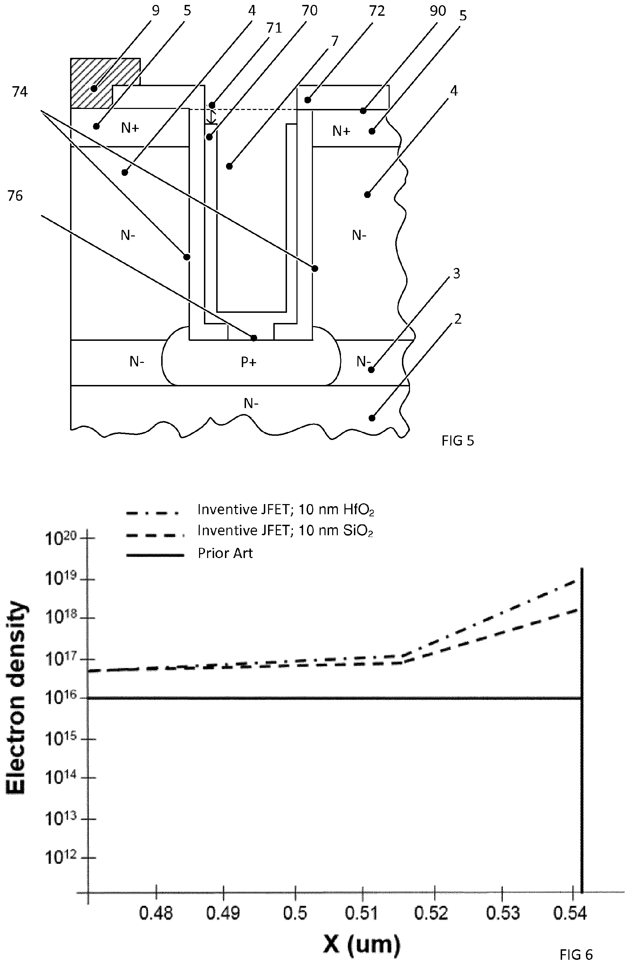

During conduction, the gate is biased with a positive voltage to a few volts, exemplarily to a voltage of at maximum + 2.5 V for an n channel JFET (having an n doped drain and drift layer). Due to the positive voltage at the gate and due to the thin insulating layer between gate and n doped mesa region, an accumulation layer along the MOS interface (interface between gate and n doped mesa region) in the MESA region may be created during operation in forward direction (i.e. with positive drain voltage), thus leading to reduced conduction losses (as shown in FIG 6). With the positive voltage, charges from the drain are attracted by the p doped gate region. Due to a weak positive voltage being applied at the gate, such charges are weakly repelled from the gate electrode so that they accumulate in the mesa region along the interface to the gate electrode and flow to the source electrode. FIG 6 shows the accumulation layer through the trench - mesa region interface for a prior art JFET and different inventive JFETs along a dotted line A - A' in FIG 1. For a higher voltage, a larger electron accumulation may be achieved. The influence of the material of the insulating layer is also obvious from FIG 6, in which a 10 nm thick insulating layer is applied, which is exemplarily SiO₂ or HfO₂, which even achieves a higher accumulation of electron density.

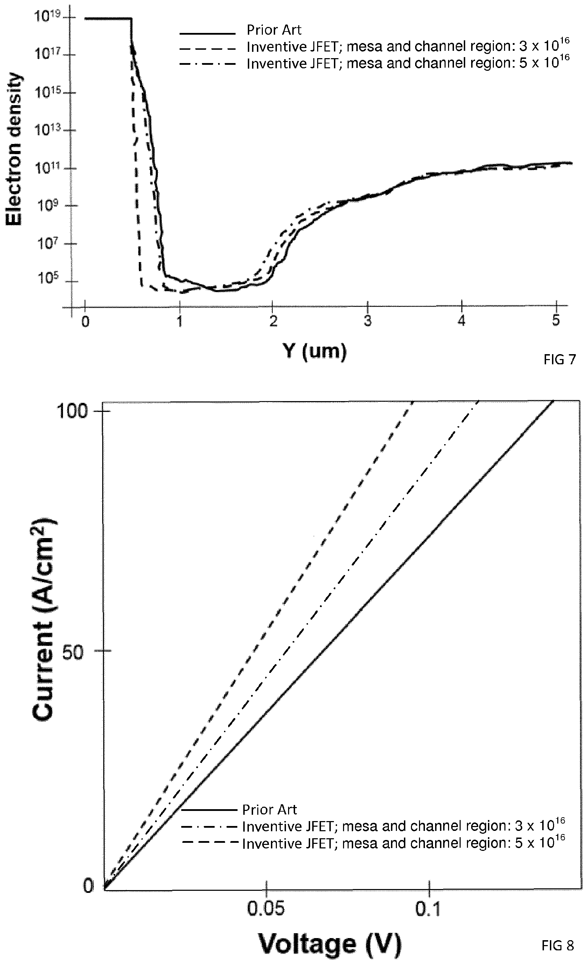

In the inventive device, the drain to source leakage current is reduced. Under negative gate bias, a pinch-off effect, by which due to the electric field from the p doped gate region blocks the electron flow from the drain to source electrode, is increased, because the pinch-off effect is created in the inventive device not only by the p+/n channel junction (like in a prior art JFET), but also by the MOS interface along the MESA region (as shown in FIG 7 for operation in blocking mode along a dotted-dashed line B - B' in FIG 1). This effect is due to the fact that the barrier to block the electrons is not only provided by the reversed biased p+ gate/n- drift junction but also by the MOS structure present in the MESA region between the p+ gate and the n+ source. In FIG 7, a prior art JFET with a doping concentration of 1 x 10¹⁶ cm⁻³ in the drift layer, channel region and mesa region is compared to an inventive JFET also having a doping concentration of 1 x 10¹⁶ cm⁻³ in the drift layer, but an enhanced doping concentration of 3 x 10¹⁶ cm⁻³ or 5 x 10¹⁶ cm⁻³ in the channel and mesa region. For the inventive JFET with the doping concentration of 3 x 10¹⁶ cm⁻³ the leakage current is further reduced compared to an inventive device having a higher doping concentration in the mesa and channel region and to the prior art device.

Furthermore, the doping concentrations in the mesa region or the channel region or both regions may be increased in an inventive JFET, exemplarily by a factor of 5 up to 10 higher than the doping concentration of the drift layer. This results in more than 30 % reduction of the specific on-state resistance so that the device may be operated at higher currents. Depending on the design requirement of the device, the doping concentration of the mesa region and the channel region may be adapted to achieve an optimum balance between leakage current and conduction losses. FIG 8 shows the influence of the doping concentrations in the mesa and channel regions for the same devices as for FIG 7. The highest doping concentration in the mesa and channel region allow the device to be operated at the highest current (or to reduce the voltage in forward direction). Therefore, it depends on the desired electrical properties which doping concentration may be used for the mesa region and channel region in order to achieve good or at least acceptable leakage currents while having lowest or at least lower conduction losses than prior art devices.

In an inventive device, it is also possible to reduce the thickness of the gate region , i.e. which is also the thickness of the channel region, or the thickness of the mesa region or both due to the improved blocking and conduction properties which again further reduces the conduction losses.

Although the present invention has been described in relation to particular embodiments, many other design variations and modifications will be apparent for those skilled in the art. The present invention describes solely active areas, though the present embodiments can be associated to different termination designs, including those containing both p and n layers. The present invention can also be associated to other device concepts.

Further exemplary embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view of an inventive JFET device;
- FIG 2: shows a cross sectional view of another inventive JFET having a higher doped channel region and mesa region;
- FIG 3: shows the area of the dashed circle of FIG 1 in an enlarged view;
- FIG 4: shows the area of the dashed circle of FIG 1 of another inventive JFET having a p gate region which is wider than trench;
- FIG 5: shows the area of the dashed circle of FIG 1 of another inventive JFET having a p gate region which covers an edge of the trench;
- FIG 6: shows the area of the dashed circle of FIG 1 of another inventive JFET having a p gate region which covers an edge of the trench;
- FIG 7: shows the area of the dashed circle of FIG 1 of another inventive JFET having a p gate region which covers an edge of the trench;
- FIG 8: shows the area of the dashed circle of FIG 1 of another inventive JFET having a p gate region which covers an edge of the trench;
- FIG 9: shows a prior art JFET device.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

FIG 1 shows a cross sectional view of an inventive junction field-effect transistor (JFET), which comprises from a drain side 80 to a source side 90 following layers:
- a drain layer 1 of a first conductivity type, which contacts a drain electrode 8,
- a drift layer 2 of the first conductivity type, which is lower doped than the drain layer 1,
- a channel region 3 of the first conductivity type, which is doped as least as high as the drift layer 2,
- a mesa region 4 of the first conductivity type, which is doped as least as high as the drift layer 2,
- a source layer 5 of the first conductivity type, which is higher doped than the mesa region 4, wherein the source layer 5 contacts a source electrode 9.

The source side 90 lies opposite to the drain side 80. It is a plane through such side of the source layer 5 opposite to the mesa region 4, i.e. it is the plane of the outermost doped region of the JFET. The source layer 5 extends to a source layer depth 50 from the source side 90. The source layer 5 is arranged on the mesa region 4, which is the only doped layer, which the source layer 5 contacts. The source layer 5 does not contact a p doped layer.

Exemplarily, the n+ doped source layer 5 has a doping concentration equal to or more than 5 x 10¹⁸ cm⁻³. The doping concentration may be constant in the source layer 5. The source layer 5 may have a thickness between 0.1 µm and 1.5 µm, which shall be the extension of the source layer 5 from the source side 90 to the source layer depth 50.

A recess in form of a trench 7, 7' extends from the source side 90 through the source layer 5 and the mesa region 4 to the gate region 3. Exemplarily, the trench 7, 7' has a width between 0.5 µm and 5 µm. A width shall correspond to a maximum diameter of a circle that may be laid into the trench 7, 7' (or region) in a plane parallel to the source side 9.

The trench 7, 7' has a lateral trench side wall 74, 74' and a trench bottom 76, 76'. Exemplarily, the trench side wall 74, 74' lies perpendicular to the source side 90. The trench side wall 74, 74' extends from the source side 90 to the trench bottom 76, 76', which trench bottom 76, 76' is arranged exemplarily opposite to the source side 90. The trench side wall 74, 74' is covered with an insulating layer 72, 72', which has a width between 5 to 100 µm. The electrically conductive gate layer 70, 70' covers the insulating layer 72, 72' on a side opposite to the trench side wall 74, 74', i.e. inside the trench 7, 7'. Thereby, the insulating layer 72, 72' separates the gate layer 70, 70' from the n doped layer, i.e. the source layer 5, the mesa region 4 and the channel region 3. The insulating layer 72, 72' also separates the gate layer 70, 70' from the source electrode 9. The insulating layer 72, 72' may be made of an insulating material, wherein also a dielectric like a metal oxide, exemplarily Silicon dioxide, shall be considered as an insulating layer. Exemplarily, a dielectric material is a high-k dielectric material, which shall mean a dielectric material having a relative permittivity of at least 3.9. Exemplary materials for the insulating layer are SiO₂, HfO₂, Al₂O₃, Si₃N₄ and AlN or a combination/stack formed by these materials.

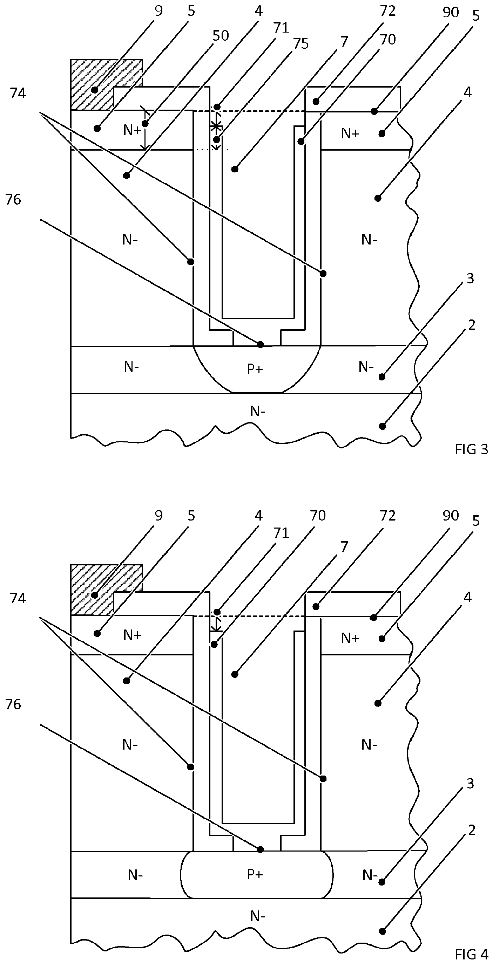

The gate layer 70, 70' extends from the gate bottom 76, 76' towards the source side 90 to a depth from the source side 90, which is less than the source layer depth 50. That means that in a direction perpendicular to the source side 90, the gate layer in projection overlaps with the source layer 5 resulting in an overlap region 75 (shown in FIG 3, which is a magnification of the dotted circle of FIG 1). The gate layer 70, 70' may be completely overlap with the projected source layer 5, which means that the gate layer 70, 70' may extend to the source side 90, but it is also possible that the gate layer 70, 70' is terminated in a distance from the source side 90, which distance is less than the source layer depth 50, but greater than zero. The gate layer 70, 70' forms an ohmic contact to the p gate region 6, 6'. Also the source electrode 9 forms an ohmic contact to the source layer 5 and the drain electrode 8 to the drain layer 1.

A p doped gate region 6, 6' is arranged below the trench 7, 7', wherein the gate layer 70, 70' contacts the gate region 6, 6' at the trench bottom 76, 76'. The gate region 6, 6' is higher doped than the drift layer 2. The p doped gate region 6, 6' is in contact to the n- doped drift layer 2 below the gate region 6, 6' and to the n doped channel region 3 lateral to the gate region 6, 6'. There is no contact from the p doped gate region 6, 6' (or any other p doped layer) to the n+ doped source layer 5. The gate region 6, 6' may be limited to a region below the trench 7, 7' as shown in FIG 3. In another exemplary embodiment, the gate region 6 laterally projects the trench 7 as shown in FIG 4, but remains in an area below the trench 7. In a further embodiment as shown in FIG 5, the p gate region 6 projects the trench 7 and even covers the edge between the trench bottom 76 and the trench side wall 74, i.e. extends to a depth less than the depth of the trench bottom 76, but exemplarily to a depth of more than 80 % of the depth of the trench bottom 76, so that the gate region 6 is separated from the source layer 5 by an n doped layer (i.e. the mesa region 4). In any case, in the area below the source layer, the n doped mesa region 4 extends to the insulating layer 74, thereby ensuring that an accumulation layer is formable for operation in forward direction.

The drift layer 2 is a lowly n- doped layer between the channel region and gate region 3, 6, 6' and the highly n+ doped drain layer 1. The doping concentration is exemplarily between 1 x 10¹⁴ cm⁻³ and 5 x 10¹⁶ cm⁻³. In an exemplary embodiment, the doping concentration is constant in the drift layer 2. The thickness of the drift layer 2 depends on the desired maximum blocking voltage of the device, exemplarily the drift layer thickness is between 3 µm and 200 µm.

The drain layer 1 may have a doping concentration of at least 5 x 10¹⁸ cm⁻³ and exemplarily a thickness between 70 µm and 250 µm.

The channel region 3 shall be such n doped layer, which extends from the trench bottom 76, 76' to a gate region bottom. The channel region 3 touches the below lying drift layer 2. The channel region 3 may have the same doping concentration as the drift layer 2 (FIG 1) or higher doping concentration than the drift layer 2 (FIG 2). In an exemplary embodiment, the doping concentration of the channel region 3 is up to a factor of 10 higher than the doping concentration of the drift layer 2. It may be a factor between 5 to 10 higher, resulting in a doping concentration between 5 x 10¹⁴ cm⁻³ and 5 x 10¹⁷ cm⁻³. A channel region thickness may be between 0.3 µm and 4 µm. The doping concentration in the channel region 3 may be constant or it may vary, exemplarily it may rise towards the source side 90 to a maximum doping concentration, which may be up to a factor of 10 higher than the doping concentration of the drift layer 2. The channel region 3 may also comprise a region of constant doping concentration, e.g. of the doping concentration of the drift layer, towards the drift layer, and a region of higher doping concentration towards the mesa region 4.

The mesa region 4 shall be such n doped layer, which is arranged below and in contact to the source layer 5 down to the plane parallel to the source side 90, in which the trench bottom 76, 76 is arranged. The mesa region 4 may have the same or higher doping concentration as the drift layer 2. In an exemplary embodiment, the doping concentration of the mesa region 4 is up to a factor of 10 higher than the doping concentration of the drift layer 2. It may be a factor between 5 to 10 higher, resulting in a doping concentration between 5 x 10¹⁴ cm⁻³ and 5 x 10¹⁷ cm⁻³. A mesa region thickness may be between 0.3 µm and 5 µm. The doping concentration in the mesa region 4 may be constant or it may vary, exemplarily it may rise towards the source side 90 to a maximum doping concentration, which may be up to a factor of 10 higher than the doping concentration of the drift layer 2. The mesa region 4 may have the same (maximum) doping concentration as the channel region 3 or it may have a different doping concentration. Both mesa region 4 and channel region 3 may have the same or higher doping concentration as the drift layer 2. FIG 3 shows exemplarily an inventive JFET with higher doping concentration of the mesa region 4 and the channel region 3 than the drift layer 2. The source layer 5 and the mesa region 4 touch the trench 7, 7' at the trench side wall 74, 74' and thereby ensure that in an area of the source layer 5 and below the source layer 5 (i.e. in the area of the mesa region 4) the insulating layer 72, 72' is in contact only to n doped layers. The insulating layer 72, 72' touches a p doped layer (i.e. gate region 6, 6') only at the trench bottom 76, 76', eventually also at the lower part of the trench side walls 74, 74'.

In an exemplary embodiment, the doped layers are made of a wide bandgap material, exemplarily of silicon carbide such as 4H SiC or of gallium nitride. In another exemplary embodiment, the doped layers may be made of silicon.

In another exemplary embodiment, the gate layer 70, 70' extends towards the source side 90 from the trench bottom 76, 76' towards the source side 90 to a depth 71, which is between 0.05 µm and 0.5 µm less than the source layer depth 50, i.e. the gate layer 70, 70' has a distance to the source side 90, which is less than the source layer thickness 50, so that an electric field is formable from the gate layer 70, 70' through the thin insulating layer 72, 72' to the source layer 5.

The gate layer 70, 70' may comprise an electrically conductive material such as Ni, Ti, Al, W, a heavily doped poly silicon (higher than 10¹⁹ cm⁻³) and NiSi. It may also be made of a combination of such materials.

The gate layer 70, 70' may fill up the trench 7 up to the depth 71. Alternatively, the gate layer 70, 70' may be arranged as a layer on the insulating layer 72, 72' leaving an area around central axis of the trench 7. In this central area, a further electrically conductive layer, exemplarily a polysilicon layer may be arranged.

The gate region 6, 6' contacts the gate layer 70, 70' at the trench bottom 76, 76'. Exemplarily, it has a doping concentration of at least 5 x 10¹⁸ cm⁻³ or even at least 1 x 10¹⁹ cm⁻³. The thickness of the gate region 6, 6', i.e. the extension between the trench bottom 76, 76' and the gate region bottom may be between 0.3 µm and 4 µm.

FIG 1 shows an embodiment, in which the junction field effect transistor comprises two trenches 7, 7' and a gate region 6, 6' is arranged below each trench 7, 7'. At each trench 7, 7', a gate layer 70, 70' contacts a gate region 6, 6' at the trench bottom 76, 76'. The mesa region 4 is arranged between the insulating layer 72, 72' of the two neighboured trenches 7, 7'. The channel region 3 is arranged between the gate regions 6, 6' below the two neighboured trench 7, 7'. The mesa region 4 (as well as the channel region 3) exemplarily has a width between 0.2 and 2 µm between the neighboured trenches.

Depending on the application, the inventive JFET may also comprise more than two trenches, exemplarily up to 1000 trenches 7, 7' or the inventive JFET may consist of only one trench 7. For one trench, the inventive JFET may comprise one source contact as source electrode 9 or the device may comprise two contacts (at both lateral sides of the trench 7 similar to the two source contacts shown in FIG 1 on the right and left side of the trench 7. The trenches may be formed in periodical shapes. The trenches 7, 7' may be formed in stripe, square, rectangular or hexagonal shapes.

In a further exemplary embodiment, the conductivity types of the layers are switched, i.e. all layers of the first conductivity type are p type (e.g. the drain layer 1, the drift layer 2, the channel region 3, the mesa region 4 and the source layer 5) and all layers of the second conductivity type are n type (e.g. the gate region 6, 6').

### Reference List

- 1: drain layer
- 2: drift layer
- 3: channel region
- 4: mesa region
- 5: source layer
- 50: source layer depth
- 6, 6': gate region
- 7, 7': trench
- 70, 70': gate layer
- 71: depth (depth from source side, by which the gate layer is separated from the source side)
- 72, 72': insulating layer
- 73: further insulating layer
- 74, 74': trench side wall
- 75: overlap region
- 76, 76': trench bottom
- 8: drain electrode
- 80: drain side
- 9: source electrode
- 90: source side

## Claims

1. A junction field effect transistor comprising from a drain side (80) to a source side (90) following layers:
- a drain layer (1) of a first conductivity type, which contacts a drain electrode (8),
- a drift layer (2) of the first conductivity type, which is lower doped than the drain layer (1),
- a channel region (3) of the first conductivity type, which is doped at least as high as the drift layer (2),
- a mesa region (4) of the first conductivity type, which is doped at least as high as the drift layer (2),
- a source layer (5) of the first conductivity type, which is higher doped than the mesa region (4), wherein the source layer (5) contacts a source electrode (9), which source layer (5) extends to a source layer depth (50) from the source side (90),
wherein a trench (7, 7') extends from the source side (90) through the source layer (5) and the mesa region (4) to the channel region (3),
wherein the trench (7, 7') has a lateral trench side wall (74, 74') and a trench bottom (76, 76'), wherein the trench side wall (74, 74') extends from the source side (90) to the trench bottom (76, 76'),
wherein the trench side wall (74, 74') is covered with an insulating layer (72, 72'), which has a thickness between 5 to 100 µm,
wherein an electrically conductive gate layer (70, 70') covers the insulating layer (72, 72') on a side opposite to the trench side wall (74, 74'), wherein the insulating layer (72, 72') separates the gate layer (70, 70') from the layers of the first conductivity type (5, 4, 3), wherein the gate layer (70, 70') extends from the trench bottom (76, 76') to a depth from the source side (90), which is less than the source layer depth (50),
wherein a gate region (6, 6') of a second conductivity type different from the first conductivity type, which is higher doped than the drift layer (2), is arranged below the trench (7, 7'), wherein the gate layer (70, 70') contacts the gate region (6, 6') at the trench bottom (76, 76'), wherein the mesa region (4) extends from the source layer (5) to the trench bottom (76, 76') and the channel region (3) extends from the trench bottom (76, 76') to a gate region bottom.

2. The junction field effect transistor according to claim 1, **characterized in, that** at least one of the channel region (3) and the mesa region (4) or the channel region (3) and the mesa region (4) have a higher doping concentration than the drift layer (2).

3. The junction field effect transistor according to claim 2, **characterized in, that** at least one of the channel region (3) and the mesa region (4) or the channel region (3) and the mesa region (4) have a doping concentration, which is a factor of 5 to 10 higher than the drift layer (2).

4. The junction field effect transistor according to anyone of the claims 2 or 3, **characterized in, that** at least one of the channel region (3) and the mesa region (4) have a doping concentration between 5 x 10¹⁴ cm⁻³ and 5 x 10¹⁷ cm⁻³.

5. The junction field effect transistor according to anyone of the claims 2 to 4, **characterized in, that** the channel region (3) and the mesa region (4) have the same doping concentration.

6. The junction field effect transistor according to anyone of the claims 1 to 5, **characterized in, that** the gate layer (70, 70') extends from the trench bottom (76, 76') to to a depth (71) from the source side (90), which is between 0.05 and 0.5 µm less than the source layer depth (50).

7. The junction field effect transistor according to anyone of the claims 1 to 6, **characterized in, that** the gate layer (70, 70') comprises at least one of Ni, Ti, Al, W or polysilicon.

8. The junction field effect transistor according to anyone of the claims 1 to 7, **characterized in, that** the trench (7, 7') is filled up with the gate layer (70, 70').

9. The junction field effect transistor according to anyone of the claims 1 to 7, **characterized in, that** the trench (7, 7') comprises along a central axis a further electrically conductive layer or a polysilicon layer, which fills up the trench (7, 7').

10. The junction field effect transistor according to anyone of the claims 1 to 9, **characterized in, that** the mesa region (4) has a thickness between 0.3 and 5 µm.

11. The junction field effect transistor according to anyone of the claims 1 to 10, **characterized in, that** the channel region (3) has a thickness between 0.3 and 4 µm.

12. The junction field effect transistor according to anyone of the claims 1 to 11, **characterized in, that** the junction field effect transistor comprises at least two trenches (7, 7') and **in that** a gate region (6, 6') is arranged below each trench (7, 7'), wherein at each trench (7, 7') a gate layer (70, 70') contacts a gate region (6, 6') at the trench bottom (76, 76').

13. The junction field effect transistor according to claim 12, **characterized in, that** the at least two trenches (7, 7') are formed in periodical shapes.

14. The junction field effect transistor according to anyone of the claims 12 or 13, **characterized in, that** the at least two trenches (7, 7') are formed in stripe, square, rectangular or hexagonal shapes.

15. The junction field effect transistor according to anyone of the claims 12 to 14, **characterized in, that** the mesa region (4) has a width between two trenches (7, 7') between 0.2 and 2 µm.
